# EUROPEAN PATENT SPECIFICATION

(11) **EP 1 670 015 B1**
(45) Date of publication and mention of the grant of the patent: **14.12.2016**
(21) Application number: 04772724.3
(22) Date of filing: 27.08.2004
(51) Int. Cl.: C23C 16/34, C23C 16/48, H01J 1/304, H01J 9/02

(54) **SP SP 3 /SP BONDING BORON NITRIDE THIN FILM HAVING SELF-FORMING SURFACE SHAPE BEING ADVANTAGEOUS IN EXHIBITING PROPERTY OF EMITTING ELECTRIC FIELD ELECTRONS, METHOD FOR PREPARATION THEREOF AND USE THEREOF**
SP SP 3 /SP BOND-BORNITRID-DÜNNFILM MIT SELBSTFORMENDER OBERFLÄCHENFORM MIT VORTEILEN BEI DEM ZEIGEN DER EIGENSCHAFT DES EMITTIERENS VON ELEKTRISCHEN FELDELEKTRONEN, HERSTELLUNGSVERFAHREN DAFÜR UND VERWENDUNG DAFÜR
FILM MINCE DE NITRURE DE BORE A LIAISON SP SP 3 /SP PRESENTANT UNE FORME DE SURFACE AUTOFORMEE QUI POSSEDE UNE PROPRIETE AVANTAGEUSE D'EMISSION D'ELECTRONS DE CHAMP ELECTRIQUE, PROCEDE DE PREPARATION ET UTILISATION ASSOCIES

(30) Priority: 29.08.2003 JP 2003209489
(43) Date of publication of application: 14.06.2006
(73) Proprietor: National Institute for Materials Science, Tsukuba-shi, Ibaraki 305-0047 (JP)
(72) Inventor: Komatsu, Shojiro, Tsukuba-shi, Ibaraki 305-0047 (JP); Moriyoshi, Yusuke, Shibuya-ku, Tokyo 150-0036 (JP); Shimizu, Yoshiki, Nerima-ku, Tokyo 176-0014 (JP); Okada, Katsuyuki, Tsukuba-shi, Ibaraki 305-0047 (JP)
(74) Representative: V.O.
(86) International application number: PCT/JP2004/012775
(87) International publication number: WO 2005/022578

(56) References cited:
- EP-A- 0 945 884
- WO-A-2004/005186
- JP-A- 3 079 770
- JP-A- 5 004 808
- JP-A- 6 316 402
- JP-A- 10 001 304
- JP-A- 2001 351 506
- JP-A- 2002 100 281
- JP-A- 2002 352 694
- SUGINO T ET AL: "Tunneling controlled field emission of boron nitride nanofilm" DIAMOND AND RELATED MATERIALS, ELSEVIER SCIENCE PUBLISHERS, AMSTERDAM, NL, vol. 12, no. 3-7, March 2003 (2003-03), pages 464-468, XP004423697 ISSN: 0925-9635
- SUGINO TAKASHI ET AL: "Field emission characteristics of boron nitride films" JOURNAL OF VACUUM SCIENCE & TECHNOLOGY B: MICROELECTRONICS PROCESSING AND PHENOMENA, AMERICAN VACUUM SOCIETY, NEW YORK, NY, US, vol. 18, no. 2, March 2000 (2000-03), pages 1089-1092, XP012008081 ISSN: 0734-211X
- KIMURA CHIHARU ET AL: "Electron field emission from boron nitride nanofilm and its application to graphite nanofiber" JOURNAL OF VACUUM SCIENCE & TECHNOLOGY B: MICROELECTRONICS PROCESSING AND PHENOMENA, AMERICAN VACUUM SOCIETY, NEW YORK, NY, US, vol. 21, no. 5, September 2003 (2003-09), pages 2212-2216, XP012010091 ISSN: 0734-211X
- KOMATSU SHOJIRO ET AL: "Highly crystalline 5H-polytype of sp3-bonded boron nitride prepared by plasma-packets-assisted pulsed-laser deposition: An ultraviolet light emitter at 225 nm", APPLIED PHYSICS LETTERS, AMERICAN INSTITUTE OF PHYSICS, vol. 81, no. 24, 9 December 2002 (2002-12-09), pages 4547-4549, XP012032745, ISSN: 0003-6951, DOI: 10.1063/1.1527987

## Description

### Technical Field

The present invention relates to a membrane body of boron nitride, or sp³-bonded boron nitride whose structure is represented by general formula BN, which has a surface texture excellent in field electron emission, method for producing such a membrane body and use thereof.

More specifically, the present invention relates to the aforementioned novel material which allows the formation of a film having an extraordinarily high field electron emission ability (the density of resulting current being 1000 times or more as high as that of a corresponding conventional film) which is intended to be applied in the field of lamp-type light source devices based on field electron emission, or field emission type displays.

### Background Art

Recently, in the technical fields related with the materials capable of electron emission ability, various materials capable of electron emission have been proposed, and those that can withstand high voltage or allow the generation of high density current have been sought. As one of the materials that satisfy such demands, carbon nanotube attracts recently the attention of people concerned. However, if carbon nanotube is to be used as a material for producing a film suitable for electron emission, it will be necessary to devise a new technique whereby one can enhance its electron emission ability, that is, to raise the density of resulting current.

Therefore, attempts have been made to enhance the electron emission ability of a nanotube film by growing nanotubes into a film with a pattern specifically aimed at the enhanced emission of electrons, or modifying a nanotube film using print transcription technique so that it has a form suitable for the enhanced emission of electrons.

However, the nanotube film obtained as a result of such laborious, exquisite technique only allows the generation of electric current whose density is at most in the order of mA/cm². In addition, the film imposes a limitation for the intensity of applied voltage, and if applied voltage were higher than that limitation, the film would degrade soon and its superficial layers be torn off, i.e., the film could not withstand use under high voltage for a sufficiently long period of time.

### Disclosure of Invention

### Problems to be Solved by the Invention

In view of the current situation described above, the present invention tries to meet the demand manifest in the field electron emission technique, thereby accelerating progress in this promising field. Put specifically, the object of the present invention is to provide a novel material capable of achieving stable field electron emission, that is, capable of withstanding the high intensity of electric field, stably emitting a large amount of electrons in terms of the density of current for a long period of time without undergoing degradation or damage.

### Means for Solving the Problems

To achieve the above object, the present inventors noticed boron nitride which has been used as a heat-resistant, anti-corrosive material, and recently attracts attention as a newly elaborated material. They studied hard to design a material capable of electron emission based on the material. They found that among boron nitride compounds produced under a certain condition, there are some that, when grown into a film, produce a film having a surface texture that exhibits excellent field electron emission, and tolerance against the high intensity of applied electric field.

The finding made and confirmed by the inventors is as follows. Boron nitride is allowed to deposit on a substrate via vapor-phase reaction. During this operation, when a high energy UV beam is radiated close to the substrate, boron nitride deposits on the substrate in the form of a membrane, and discrete dots of protrusions grow on the film in a self-organized manner with a certain interval from each other, each protrusion having a sharp end directing upward. The resulting film, when exposed to an electric field, readily emits electrons. In addition, the film maintains the high density of current, extraordinarily high as compared with the corresponding value obtained heretofore from conventional films, that is, maintains the highly stable condition and performance without undergoing degradation or damage or torn-off, i.e., the film is found to have a very excellent electron emission ability.

The present invention is achieved based on this finding, and provides a membrane of boron nitride whose surface has a physical condition or texture so unique as to be never observed in the corresponding conventional films, and which ensures highly excellent electron emission performance, and a method for producing such a membrane, and succeeds in developing new applications based on the use of this unique material. Accordingly, the invention relates to a film on a substrate according to claim 1.

The technical constituents of the present invention are based on the requirements described in the following paragraphs (1) to (11).
(1) A film of sp³-bonded boron nitride excellent in field electron emission obtained by vapor-phase deposition in which a surface texture allowing excellent in field electron emission is formed in a self-organized manner.
(2) A film of sp³-bonded boron nitride as described in paragraph (1) excellent in field electron emission wherein the surface texture allowing excellent field electron emission comprises discrete dots of protrusions each having a sharp tip end.
(3) A film of sp³-bonded boron nitride as described in paragraph (1) or (2) excellent in field electron emission wherein the discrete dots of protrusions are separated from each other at an interval or distributed at a density suitable for field electron emission.
(4) A film of sp³-bonded boron nitride as described in any one of paragraphs (1) to (3) excellent in field electron emission which comprises polytype boron nitride such as 5H type or 6H type boron nitride.
(5) A film of sp³-bonded boron nitride as described in any one of paragraphs (1) to (4) excellent in field electron emission which is formed on a substrate as a result of vapor-phase reaction excited by a UV beam.
(6) A method for producing a film of sp³-bonded boron nitride excellent in field electron emission, characterized in comprising the steps of introducing a reactive gas including a boron source and a nitrogen source whose pressure is adjusted to 0.001 to 760 Torr into a reaction system; adjusting the temperature of a substrate in the reaction chamber to fall between room temperature and 1300ºC; radiating a UV beam onto the substrate with or without the concomitant existence of plasma; and forming via vapor-phase reaction a membrane on the substrate in which a surface texture allowing excellent field electron emission is formed in a self-organized manner.
(7) A method as described in the paragraph (6) for producing a film of sp³-bonded boron nitride excellent in field electron emission wherein the reaction gas is obtained via the dilution by a diluting gas such as a rare gas or hydrogen gas or their mixture, the dilution occurring by mixing the reaction gas with the diluting gas at a volume (%) ratio of 0.0001 - 100 to 100.
(8) A method as described in the paragraph (6) or (7) for producing a film of sp³-bonded boron nitride excellent in field electron emission wherein the reactive gas comprises diborane as a boron source and ammonia as a nitrogen source.
(9) A method as described in the paragraph (6) for producing a film of sp³-bonded boron nitride excellent in field electron emission, characterized in wherein the UV beam occurs as pulsed laser.
(10) A method as described in any one of paragraphs (6) to (9) for producing a film of sp³-bonded boron nitride excellent in field electron emission, characterized in wherein the membrane body of sp³-bonded boron nitride excellent in field electron emission comprises polytype boron nitride such as 5H type or 6H type boron nitride.
(11) A film of sp³-bonded boron nitride as described in any one of paragraph (1) to (4) excellent in field electron emission which is used as a material for electron emission.

### Effect of the Invention

The film (membrane) body of sp³-bonded boron nitride excellent in field electron emission which has a surface texture with discrete dots of protrusions each having a sharp tip end provided by this invention distributed thereon ensures the following advantages:
(1) It is low in the threshold of field electron emission;
(2) It allows the high density of current; and
(3) It has a long life in field electron emission.

The inventive material is superior as a material for field electron emission to standard conventional materials. The inventive material is particularly noteworthy in the advantages (2) and (3) (it ensures the density of current 1000 times or more higher than the conventional material, and is structurally robust and resistant as is characteristic with BN). Thus, it will bring about never-been-observed-before breakthrough if it is applied as a material in the construction of lamp-type light source devices or field emission type displays, which will be very meaningful for those concerned.

### Brief Description of the Drawings

Fig. 1 is a diagram for showing the outline of a reaction system of the invention and schematic representation of its operation.
Fig. 2 is a scanning electron-microscopy (SEM) photograph of a film prepared in Example 1 in which the formation of a self-organized texture suitable for field electron emission is confirmed on the surface.
Fig. 3 is a more enlarged SEM photograph of a film prepared in Example 1.
Fig. 4 is a graph for showing the field electron emission property of a film prepared in Example 1.
Fig. 5 is a graph for showing the stableness over time of the field electron emission of a film prepared in Example 1 plotted as a function of current density.
Fig. 6 is a graph for showing the field electron emission property of a film prepared in Comparative Example where no UV beam is used.
Fig. 7 is an SEM photograph of a film prepared in Comparative Example where no UV beam is used which was broken during experiment performed to study its field electron emission.
Fig. 8 is an SEM photograph of a film prepared in Example 2 in which the formation of a self-organized texture suitable for field electron emission is confirmed on the surface.
Fig. 9 is a graph for showing the field electron emission property of a film prepared in Example 2.

### Reference Numerals

1: Reaction chamber (reaction furnace)
2: Gas inlet
3: Gas outlet
4: Substrate upon which boron nitride is to be deposited
5: Optical window
6: Exima UV laser unit
7: Plasma torch

### Best Mode for Carrying Out the Invention

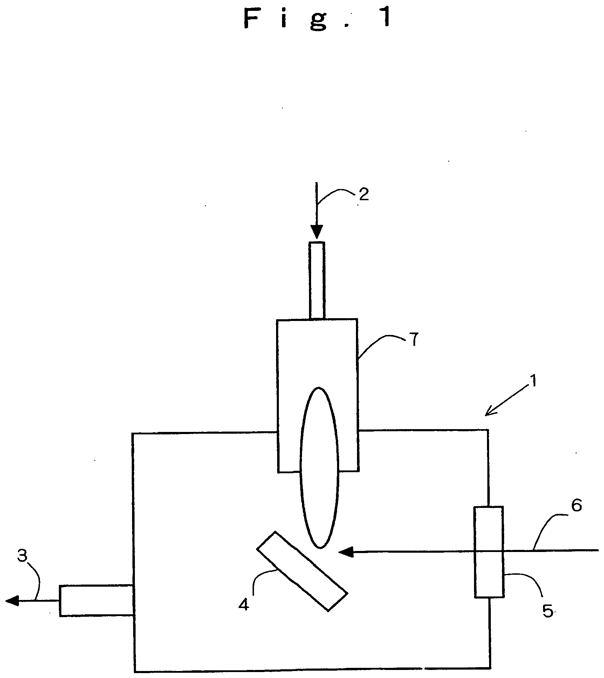

The preferred embodiments of the present invention will be described in detail below with reference to the attached drawings and Examples. Fig. 1 shows a reaction system used according to the present invention for obtaining a membrane body of sp³-bonded boron nitride excellent in field electron emission. As shown in the fig.1, the reaction system 1 comprises a gas inlet 2 for introducing a reaction gas and diluting gas, and a gas outlet 3 for evacuating the reaction gas out of the reaction chamber, and is connected to a vacuum pump in such a manner as to allow the pressure within the chamber to be maintained below the atmospheric pressure. Within the chamber, along the flow passage of gas there is provided a substrate 4 on which boron nitride will be deposited. On the wall of chamber facing the boron nitride deposition surface of substrate, there is provided an optical window 5 to which an exima UV laser unit 6 is placed such that UV light therefrom is radiated through the window onto the boron nitride deposition surface of substrate.

The reaction gas introduced into the reaction system is excited as a result of the exposure to UV light directed towards the active surface of substrate so that a nitrogen source and boron source therein undergo vapor-phase reaction to cause sp³-bonded boron nitride, and a general formula;BN is indicated, having a 5H or 6H polytype structure to be formed and deposited on the active surface of substrate, the deposition growing into a membrane thereon.

As a result of experiment, it is revealed that the formation of membrane is possible even when the pressure within the reaction system varies in a wide range of 0.001 to 760 Torr, or when the temperature within the reaction system varies in a wide range of room temperature to 1300ºC. However, to obtain the desired reaction product having a high purity, it is preferable to maintain the pressure at a low level and the temperature at a high level.

A case where, when a UV light is radiated to the active surface of substrate and its surrounding space, plasma is also evoked so as to be exposed to the UV light forms another embodiment of the invention. Indeed, in Fig. 1, the plasma torch 7 is introduced to realize such an embodiment where the inlet for introducing reaction gas and plasma torch are integrally combined with respect to the substrate such that reaction gas and plasma are directed towards the active surface of substrate.

The boron nitride membrane of the invention is produced using a reaction system as described above, and the involved procedures will be described below with reference to attached figures and concrete Examples. However, these Examples are disclosed only as an aid for facilitating the ready appreciation of the present invention. It should be understood that the scope of the invention is not limited in any way by those Examples.

In summary, the present invention aims to provide a method for producing a membrane body of sp³-bonded boron nitride excellent in field electron emission obtained by vapor-phase deposition in which a surface texture allowing excellent field electron emission is produced in a self-organized manner, and new applications where the membrane body is utilized as an electron emission material. The condition under which the object of the invention is achieved is not determined uniquely but can vary as appropriate according to given situations, and the scope of the invention includes such variations.

### EXAMPLE 1

Into a mixed dilution gas comprising argon gas flowing at 2 SLM and hydrogen gas flowing at 50 sccm were introduced diborane gas flowing at 10 sccm and ammonia gas flowing at 20 sccm, and at the same time, an exima UV laser was radiated to a silicon substrate kept at 800ºC by heating in a chamber of which the pressure of atmosphere was kept at 30 Torr by a pump engaged in the evacuation of the atmosphere (see Fig. 1). When 60 minutes were allowed to pass for synthesis, a target film was obtained. This film product was examined by the X-ray diffraction method which revealed that the material consisted of hexagonal crystal, and had an sp³-bonded, 5H polytype structure. Its lattice constants were a = 2.52 A, and c = 10.5 A.

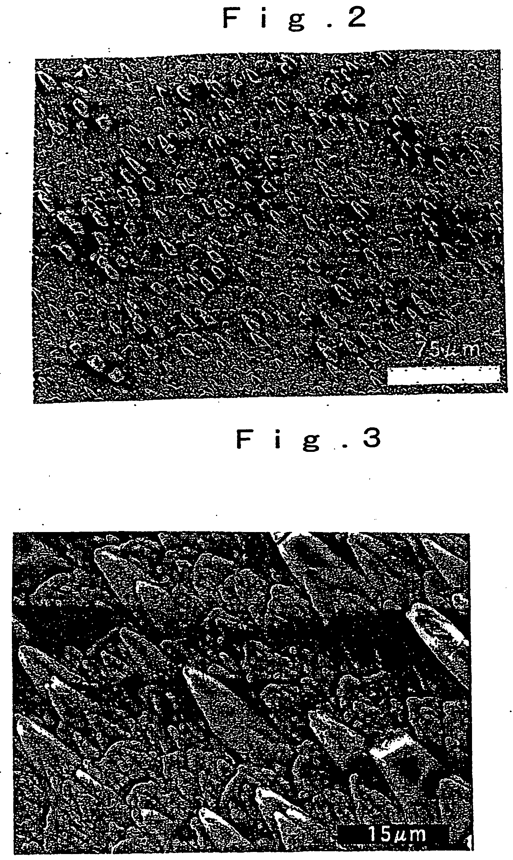

The results obtained by observing the material by scanning electron-microscopy (SEM) are represented in Figs. 2 and 3. As seen from the observation results shown in the figures, it was demonstrated that the film obtained by the inventive method has a characteristic surface texture comprising discrete dots of conical protrusions each having a sharp tip end (several to several tens microns in length) formed in a self-organized manner, each protrusion being likely to serve as a spot where electric field concentrates. Incidentally, Fig. 3 is an enlarged SEM photograph of the same photograph shown in Fig. 2.

To evaluate the field electron emission of this film, a metal cylindrical electrode having a diameter of 1 mm was placed 30 micrometer apart from the surface of the film in a vacuum chamber, and a voltage is applied between the film and the electrode, and electron emission from the film was measured.

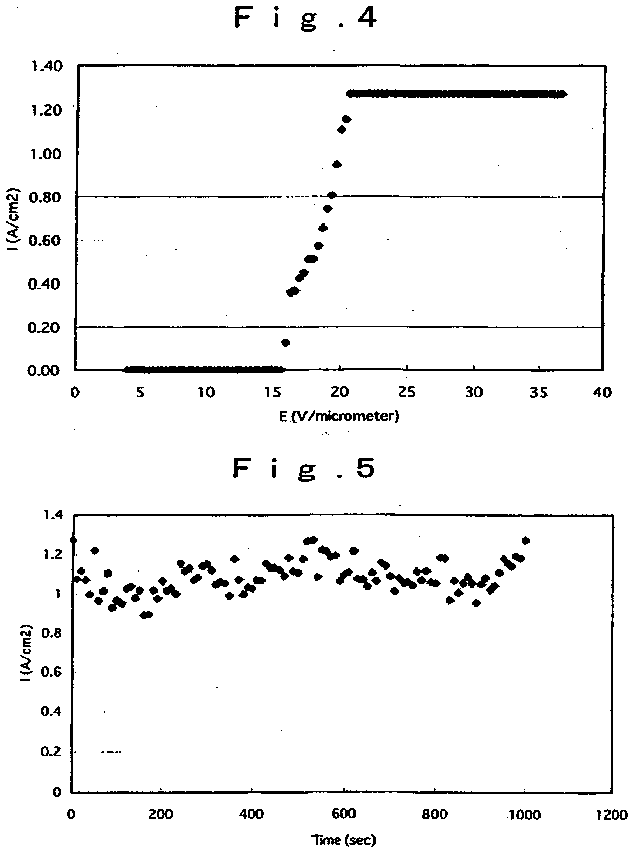

As a result, it was demonstrated that the film exhibits a characteristic as shown in Fig. 4. According to the graph shown in the figure, for the boron nitride film of the invention, the density of current starts to increase at the field intensity of 15 - 20 (V/µm), and reaches, at the field intensity of 20 (V/µm), a saturation level (equal to 1.3 A/cm²) which corresponds to the upper limit permitted for a high voltage power source used for measurement.

Then, when the field intensity was kept at a level where the current intensity value reached a saturation level, the change of current intensity value over time was followed. The result is shown in Fig. 5. Although more or less undulations were observed at around 900 sec (15 minutes), the current intensity values were fairly stabilized around the average, that is, the current intensity value did not show any decline indicative of the degradation of material, which demonstrates that the material is stable.

### COMPARATIVE EXAMPLE 1

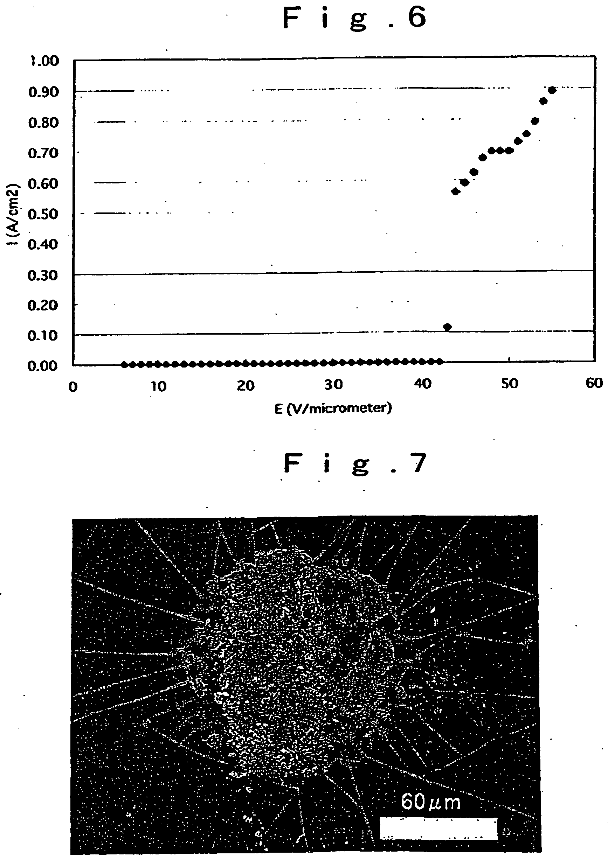

As a comparison, a film was prepared in parallel with the one of Example 1 under the same condition, except that it did not receive the irradiation of UV beam, and for a portion of the film where no UV beam was irradiated, its field electron emission was evaluated. The result is shown in Fig. 6. It was demonstrated that, for the comparative film, the threshold intensity of field responsible for the start of electron emission is 42 (V/µm) which is far higher than the corresponding value 15 (V/µm)) obtained for the experimental film which received the irradiation of UV beam.

As seen from the SEM photograph shown in Fig. 7, the film material suffered damages and torn-offs after the comparative test. By contrast, another portion of the comparative film which had a characteristic surface texture comprising protrusions grown as a result of the exposure to UV beam did not show such damages as described above after the same field electron emission evaluation test.

### EXAMPLE 2

The same reaction system with that used in Example 1 was used. Into a mixed dilution gas comprising argon gas flowing at 2 SLM and hydrogen gas flowing at 50 sccm were introduced diborane gas flowing at 10 sccm and ammonia gas flowing at 20 sccm in the system, and at the same time, the pressure of atmosphere in the chamber was kept at 30 Torr by a pump engaged in the evacuation of the atmosphere, an RF plasma with an output of 800 w and frequency of 13.56 MHz was evoked in the atmosphere, and an exima UV laser was radiated for 60 minutes to a silicon substrate kept at 900ºC by heating, to allow boron nitride to deposit on the substrate (see Fig. 1).

As a consequence, a film product was obtained. The structure of the product was determined by the same method as in Example 1, and as a result it was demonstrated that the product consisted of hexagonal crystal, and had an sp³-bonded, 5H polytype structure. Its lattice constants were a = 2.5 A, and c = 10.4 Å.

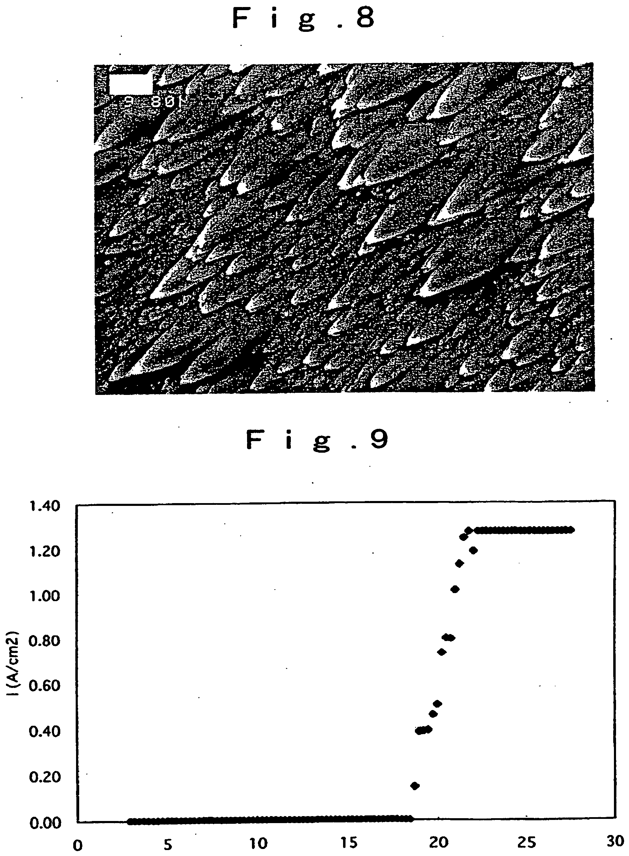

The result obtained by observing the product by SEM is as shown in Fig. 8. As seen from the figure, it was demonstrated that the film thus produced bears discrete dots of conical protrusions each having a sharp tip end

(several to several tens microns in length) which is likely to serve as a spot where electric field concentrates, that is, the surface of the substrate is covered with such protrusions. Namely, it was demonstrated by this example that the characteristic surface texture is formed in a self-organized manner.

To evaluate the field electron emission of this film, a metal cylindrical electrode having a diameter of 1 mm was placed 40 micrometer apart from the surface of the film in a vacuum chamber, and a voltage is applied between the film and the electrode, and electron emission from the film was measured. As a result of the study, the data shown in Fig. 9 were obtained. Specifically, for the film under study, the density of current starts to increase at the field intensity of 18 - 22 (V/µm), and reaches, at the field intensity of 22 (V/µm), a saturation level (equal to 1.3 A/cm²) which corresponds to the upper limit permitted for a high voltage power source used for measurement. The result showed that it is also possible to obtain a stable material as with the method of Example 1.

As seen from above, it was demonstrated that it is possible to obtain a boron nitride membrane via vapor-phase deposition performed under a condition characteristic with the present invention, in which a surface texture allowing excellent field electron emission is formed in a self-organized manner. It was also demonstrated the condition includes, as a necessary element, the irradiation of UV beam. This is apparent by referring to the difference between the Examples and the Comparative Example. However, the reason why the difference in condition between the two modes of processings lead to the creation of products so different in their characteristics as seen above remains unclear as far as based on the present state of knowledge.

However, if it were possible to assume the reaction mechanism as described below, the difference in question could be explained.

According to the suggestion given by Ilya Prigogine (Nobel prize winner) and others, formation of a surface texture in a self-organized manner can be understood as a phenomenon similar to the formation of a "Turing structure" which appears under a condition where the superficial dispersion of a precursor substance and the superficial chemical reaction compete with each other. In case of the invention, irradiation of UV light photochemically accelerates both processes, which will have an effect on the orderly arrangement of initial nuclei.

Crystal growth reaction on the surface is accelerated by the irradiation of UV light, which means that the reaction velocity increases in proportion to the intensity of light. If it were assumed that each of the initial nuclei has a semicircular shape, the summit and its environs, being exposed to the comparatively high intensity of light, are accelerated in their growth, while the periphery of semicircle, being exposed to the comparatively weak light, is retarded in its growth, which will explain why the semicircular nucleus grow into protrusions with a sharp tip end which determines the surface texture of the film of the invention.

In anyway, it can not be denied that for the formation of an inventive film, irradiation of UV light plays a key role and acts as a crucial factor.

As described above, the present invention provides a membrane body of sp³-bonded boron nitride in which a surface texture allowing excellent field electron emission is formed in a self-organized manner, the surface texture comprising discrete dots of protrusions each having a sharp tip end. Thus, it becomes possible to obtain an ideal, novel material which has a low threshold in field electron emission, allows the passage of high density of current, and ensures a long life in field electron emission without requiring any special processing means and procedures, which is very important.

### Industrial Applicability

A membrane body of sp³-bonded boron nitride excellent in field electron emission provided by the present invention has a spectacular significance as described above, and the range of uses and applications it commands is very wide and varied as is obvious from the list cited below. Thus, it is expected that the material will be exploited and incorporated in a wide variety of technical fields, thereby contributing to the progress of industry.

Since the membrane body provided by the present invention emits electrons which are 1000 times or more in terms of the density of current than those from a conventional field electron emission material, it will allow the construction of an illumination system exhibiting a ultra-high brightness at a high efficiency, or of a ultra-fine resolution display based on minute pixels each allowing the flow of sufficiently high current in spite of its being small in size (the display will be profitably incorporated in a mobile phone, ultra tiny computer, etc.), and formation of a characteristic electron emission pattern exploiting the phenomenon of a film in which one part irradiated by UV light has a higher electron emission than that of another part not irradiated by UV light. In addition, the membrane body will open the way for the construction of a nano-size electron beam source having a ultra high brightness, ultra-small electron beam source, etc. As a result, its future application will include not only illuminations and displays, but also various electric appliances and devices used in everyday life in the modern world, and revolutionize them. In short, the material of the invention commands such a rich possibility that it will permeate through the every corner of human life, to effect a global impact in technology and economics.

Furthermore, The present invention is based on the discovery of a unique phenomenon related with the formation of a film under the exposure of light in which a characteristic surface texture develops in a self-organized manner. Even if the film is used neat without being processed, the film with the surface texture allows the markedly enhanced emission of electrons. In addition, by the physical properties characteristic with the material of the film, the film is essentially free from damages due to emission of electrons, even when it maintains the flow of high density of current. If it is assumed that the film incorporated in one of the applications described above, to work there indefinitely for a permanent period, its utility as compared with the conventional equivalent material will be immense, because it will not only ensure a far longer life, but also dispense with many steps and procedures involved in the processing and patterning for field electron emission required for those conventional materials. The advent of the inventive material will ensure a leap in the development of related technology.

In summing up, the present invention provides a novel material or a film whose surface takes a characteristic texture in a self-organized manner, the film having an excellent field electron emission as a result of the cumulative effect due one part to the surface texture and the other part to the excellent physical property of the film material itself, the excellent field emission being represented by the density of current in the order of A/cm² that is 1000 times or more higher than that of a corresponding film, and the excellent physical property of the film material represented by its excellent durability. The present invention also provides the method for producing the material and the use thereof. These features of the invention will prove to be revolutionary by bringing a breakthrough on the current technical standards.

## Claims

1. A film of sp³-bonded boron nitride on a substrate excellent in field electron emission, wherein a surface texture allowing excellent in field electron emission, formed in a self-organized manner, comprises discrete dots of protrusions each having a sharp tip end, and the discrete dots of protrusions are separated from each other at an interval or distributed at a density suitable for field electron emission.

2. A film of sp³-bonded boron nitride on the substrate as described in Claim 1 excellent in field electron emission, **characterized in** which comprises polytype boron nitride such as 5H type or 6H type boron nitride.

## Patentansprüche

1. Film von sp³-gebundenem Bornitrid auf einem Substrat mit hervorragender Feldelektronenemission, wobei eine auf selbstorganisierte Weise gebildete Oberflächentextur, die hervorragende Feldelektronenemission erlaubt, einzelne Punkte von Vorsprüngen mit jeweils einer scharfen Spitze umfasst und die einzelnen Punkte von Vorsprüngen in einem Intervall voneinander getrennt sind oder in einer für Feldelektronenemission geeigneten Dichte verteilt sind.

2. Film von sp³-gebundenem Bornitrid auf dem Substrat wie in Anspruch 1 beschrieben, mit hervorragender Feldelektronenemission, **dadurch gekennzeichnet, dass** er ein Polytyp-Bornitrid wie etwa Typ 5H oder Typ 6H Bornitrid umfasst.

## Revendications

1. Film de nitrure de bore à liaisons sp³ formé sur un substrat, excellent pour l'émission d'électrons de champ, sur lequel s'est formée en auto-organisation une texture de surface conférant une excellente capacité d'émission d'électrons de champ, texture qui comprend des groupes discrets d'excroissances dotées chacune d'une extrémité en pointe aiguë, ces groupes discrets d'excroissances se trouvant séparés les uns des autres à intervalles appropriés ou répartis avec une densité appropriée pour l'émission d'électrons de champ.

2. Film de nitrure de bore à liaisons sp³ formé sur un substrat, excellent pour l'émission d'électrons de champ, conforme à la revendication 1, **caractérisé en ce qu'**il comprend un nitrure de bore polytype comme du nitrure de bore de type 5H ou de type 6H.
